(19) Europäisches Patentamt
European Patent Office
Office européen des brevets

(11) **EP 2 377 662 A1**

(12) **EUROPÄISCHE PATENTANMELDUNG**

(43) Veröffentlichungstag:
**19.10.2011 Patentblatt 2011/42**

(51) Int Cl.:
**B28D 5/00** $^{(2006.01)}$   **H01L 21/78** $^{(2006.01)}$

(21) Anmeldenummer: **11174244.1**

(22) Anmeldetag: **14.11.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **15.11.2007   DE 102007056115**
**15.11.2007   US 996396 P**

(62) Dokumentnummer(n) der früheren Anmeldung(en) nach Art. 76 EPÜ:
**08850859.3 / 2 106 331**

(71) Anmelder: **Freiberger Compound Materials GmbH 09599 Freiberg (DE)**

(72) Erfinder:
• **Hammer, Ralf**
**09599 Freiberg (DE)**
• **Jurisch, Manfred**
**01217 Dresden (DE)**

(74) Vertreter: **Prüfer & Partner GbR**
**European Patent Attorneys**
**Sohnckestraße 12**
**81479 München (DE)**

Bemerkungen:
Diese Anmeldung ist am 15-07-2011 als Teilanmeldung zu der unter INID-Code 62 erwähnten Anmeldung eingereicht worden.

(54) **Einkristall**

(57)   Es wird ein Einkristall bereitgestellt, der ausgebildet ist als vorzugsweise epitaktisch aufgewachsene Schicht auf einem Substrat, oder als Wafer, Scheibe oder Teilen davon, mit einer technologisch erzeugten Spaltfläche, die sich mit einer Winkelabweichung im Bereich von 0,02° bis —0,02° entlang einer natürlichen kristallographischen Spaltebene gemessen über die jeweils technologisch relevante Ausdehnung des Einkristalls oder über jede einer Vielzahl von Flächen mit einer Längsausdehnung in Trennrichtung von ≥ 2 mm innerhalb der technologisch relevanten Fläche erstreckt.

Fig. 10

EP 2 377 662 A1

**Beschreibung**

Die Erfindung betrifft ein Verfahren zum Trennen von Einkristallen, beispielsweise von einkristallinen Scheiben beziehungsweise Wafern oder Teilen davon. Insbesondere betrifft die Erfindung ein Verfahren zum Trennen von Einkristallen mit selbstjustierender Rissausbreitung.

Einlcristalline Wafer aus halbleitenden Materialien werden als Substrate für die Herstellung von mikroelektronischen Bauelementen wie z.B. Feldeffekt- und Heterobipolar-Tansistoren bzw. optoelektronischen Bauelementen wie Laser- und Lumineszenzdioden verwendet. Auf diesen Substraten werden durch verschiedene Verfahren wie CVD, MOCVD, LPE, MBE die Funktionsschichten abgeschieden und gegebenenfalls nachbearbeitet oder durch Ionenimplantation im Substrat erzeugt. Sie durchlaufen dann komplexe Strukturierungsprozesse unter mehrfacher Verwendung von Belichtungsmasken.

Für die Ausrichtung (Justage) der Belichtungsmasken und die gegebenenfalls erforderliche Unterscheidung von Vorder- und Rückseite weist das Substrat ein sogenanntes Orientierungflat (OF) und ein um 90˚ gegen dieses im Uhrzeiger- oder Gegenuhrzeigersinn versetztes Identifikationsflat (IF) auf. Die Wafernormale und die Flächennormale der Flats stehen in der Regel senkrecht aufeinander. Konventionelle Herstellungsprozesse von Wafern mit Flats beinhalten das Erzeugen der Flats mittels Schleifen. Die Orientierungsgenauigkeit des Orientierungsflats bezüglich der kristallographischen <110> -Richtung beträgt bei konventioneller Waferherstellung ± 1 ˚, für das Identifikationsflat ± 5˚, jedoch sind auf diese Weise auch bis ±0.02˚ für das Orientierungsflat erreichbar. Durch Schleifen hergestellte Flats können längs der Flats flukturierende Desorientierungen sowie Ausbrüche aufweisen, die ihre Funktion als Referenz für die Justage von Belichtungsmasken beeinträchtigen. Das gilt vor allem für die Herstellung von Laserdioden, für die hochpräzise und darüber hinaus störungsfreie, kantenscharfe Flats mit einer Orientierungsgenauigkeit von ≤ |0.02˚| gemessen über eine für diese Technologie relevante Länge gefordert werden.

Es ist bekannt, dass die Orientierungsgenauigkeit der Flats erhöht werden kann, wenn sie statt durch Schleifen durch ein Spalten der in der Regel spröden Halbleitermaterialien unter Verwendung der natürlichen Spaltebenen erzeugt werden. Z.B. sind bei III-V-Halbleitern die {110}-Flächen natürliche Spaltflächen. Aus der US 5,279, 077 und der US 5,439,723 sind Wafer mit derartigen durch Anspalten erzeugten Flats bekannt. Aus der US 5,154,333 ist eine Vorrichtung bekannt, mit der die Spaltung über eine definierte Biegebeanspruchung eines Wafers, in dem ein durch Ritzen erzeugter Risskeim besteht, vorgenommen wird. Ein Nachteil einer mechanischen Spaltvorrichtung besteht jedoch darin, dass die Rissausbreitung nicht kontrolliert werden kann und durch die Initialisierung des Bruches durch einen Bruchkeim am Waferrand ein komplexer Bruchmodus realisiert wird.

Alternativ gibt es thermische Trennverfahren, die mit einer Kombination von lokaler Erwärmung und benachbarter lokaler Kühlung arbeiten. Ein grundlegendes Verfahren ist das in DE 28 13 302 beschriebene Verfahren zum Schneiden von Flachglas mit Hilfe von thermisch induzierten Spannungen. Bei diesem Verfahren wird Glas auf mindestens einer der beiden Hauptoberflächen innerhalb zweier auf der vorgesehenen geraden Schnittlinie hintereinander angeordneter, scharf abgegrenzter und zur Schnittlinie symmetrischer Bereiche in einem Bereich erwärmt und im anderen Bereich abgekühlt. Die über die Glasdicke und in Richtung der Schnittlinie resultierenden Temperaturgradienten im Glas rufen Wärmespannungen hervor, die einen Riss, ausgehend vom Kantenanriss, senkrecht zu den Hauptoberflächen entlang der vorgesehenen gerade Schnittlinie treiben, wobei die Rissausbreitungsgeschwindigkeit durch Regelung der aufgebrachten Temperaturen und des Vorschubes der Heiz-/Kühlvorrichtung kontrolliert wird.

Aus WO 93/20015 ist ein Verfahren zum Trennen von Halbleiterbauelementen bekannt. Bei diesem wird durch die Bildung von Zugspannungen in einem Gebiet zwischen einem erwärmenden Laserstrahl und einer nachfolgenden Kühlung ein Bruch initiiert. Mit dem Verfahren soll die Form, die Richtung, die Tiefe und die Geschwindigkeit sowie die Genauigkeit des durch thermische Spannungen erzeugten Bruches kontrolliert werden.

Ein Merkmal der bekannten Verfahren zum Trennen von spröden Werkstoffen durch Rissausbreitung ist die Erzeugung oder das Vorhandensein eines Initialrisses. In der Umgebung der Rissspitze wird nun mit einer geeigneten Methode ein, wie z.B. der oben erwähnte mechanische Biegebeanspruchung oder mit thermischer Beaufschlagung ein Spannungsfeld erzeugt. Dieses Spannungsfeld führt zu einer komplexen Beanspruchung an der Rissfront, die durch den Spannungsintensitätsfaktor K gekennzeichnet wird. Wird das Spannungsfeld so gewählt, das gilt

$$K > K_C, \qquad\qquad\qquad (1.1)$$

wobei $K_C$ der materialspezifische Spannungsintensitätsfaktor ist, so wächst die Risslänge so lange, bis die Bedingung

$$K \leq K_C \qquad\qquad\qquad (1.2)$$

erfüllt ist. K > K$_C$ ist die Fortschreitbedingung für den Trennprozeß, die kontinuierlich oder in Intervallen aufrechterhalten werden muß, bis die vollständige Trennung erreicht ist.

Die Rissausbreitung verläuft nach dem Prinzip der Minimierung der freien Energie des zu trennenden Körpers. Das bedeutet, dass der Riss sich derart ausbreitet, dass in isotropen Werkstoffen die mechanische Energiefreisetzungsrate G maximal ist. In anisotropen Werkstoffen konkurriert bei der Minimierung der Gesamtenergie des Systems während der Rissausbreitung das Prinzip der Minimierung der effektiven Oberflächenenergie 2y$_e$ der getrennten Flächen mit dem Prinzip der Maximierung der mechanischen Energiefreisetzungsrate.

$$\frac{dU}{dC} = 2\gamma_e - G \longrightarrow Min \qquad (1.3)$$

wobei U die Gesamtenergie des Systems und C die durch Rissausbreitung erzeugte Fläche ist.

Für die oben genannten Verfahren bedeutet das, dass bei isotropen Werkstoffen die zeit- und ortsabhängigen Spannungsfelder den Verlauf des Risses kontrollieren. Beim Vorhandensein von kristallographischen Spaltebenen, die sich durch minimale effektive Oberflächenenergie auszeichnen, konkurrieren beim Rissfortschritt die durch die Spannungsfelder erzwungene Rissausbreitungsrichtung (G → max) mit den Richtungen dieser kristallographischen Spaltebenen, die eine minimale effektive Oberflächenenergie aufweisen. Deshalb gelingt es in der Praxis mit den genannten Verfahren nur Spaltebenen herzustellen, die Stufen und Sprünge in die benachbarten Netzebenen aufweisen. Dies wirkt sich nachteilig auf technologisch relevante Spaltflächen, wie Resonatorflächen von Laserbauelementen und Orientierungsabweichungen gespaltener Flats aus.

Die Herstellung absolut ebener Spaltflächen würde theoretisch dann gelingen, wenn ein ebenes Zugspannungsfeld senkrecht zur gewünschten Spaltebene erzeugt wird. In diesem Fall wären die Spannungsfelder und die Spaltebenen so aufeinander abgestimmt, dass sie nicht miteinander konkurrieren. Diese Bedingungen sind in der Praxis nicht einzuhalten. Es würde zum Beispiel für das Spalten von Laserbauelementen erfordern, dass der Wafer hochpräzise zur Spaltvorrichtung orientiert werden muß, um zumindest über die Länge eines Laserbauelements hinreichende Qualität der Spaltebene zu erreichen. Selbst bei kleinsten Abweichungen der Waferorientierung bezüglich der erzeugten Spannungsfelder sind Stufen auf der Spaltebene unvermeidbar.

Es ist Aufgabe der Erfindung, ein Verfahren zum Trennen von Einkristallen bereitzustellen, welches die oben genannten Nachteile vermeidet und exakte Spaltebenen über die gesamte Distanz bis zum völligen Abtrennen der gewünschten Teile sichert.

Die Aufgabe wird gelöst durch ein Verfahren nach Patentanspruch 1 sowie durch einen Einkristall gemäß den Ansprüchen 13 oder 14. Weiterbildungen der Erfindung sind in den Unteransprüchen angegeben.

Das Verfahren weist den Vorteil auf, dass die vorherige Bestimmung und Justierung der kristallographischen Spaltebenen zur Spaltvorrichtung lediglich mit praxisüblichen Genauigkeiten erforderlich ist. Die exakte Orientierung des sich ausbreitenden Risses wird durch die erfindungsgemäßen Prozeßbedingungen gesichert, die eine Selbstjustierung der Rissausbreitungsrichtung in genau einer der kristallographischen Spaltebenen ohne Stufen und Sprünge erzwingen.

Aufgrund der Erfindung sind Spaltflächen mit Genauigkeiten im Bereich von ≤ |0,02˚|, |0,01˚|, |0,005˚| oder sogar |0,001˚| - gemessen über die Ausdehnung der jeweils technologisch relevanten Fläche oder einer Vielzahl von Teilflächen davon - erzielbar. Die jeweils technologisch relevante Fläche entspricht im Fall von Laserdioden beispielsweise der Länge eines Laserresonators oder im Fall von integrierten Schaltkreisen der Randlänge des abzutrennenden Chips. Beim Abspalten vom Wafer zur Bildung von Flats entspricht sie der Flatlänge. Auch die Herstellung einer natürlichen Spaltfläche ist aufgrund der hier vorgeschlagenen selbstadjustierten Spaltung möglich.

Die Orientierungsgenauigkeit einer Trennfläche bezüglich einer kristallographischen Netzebene wird gemessen durch Anlegen des Kristalls an eine Referenzfläche, wobei mindestens 2 Punkte der Trennfläche zum Anschlag kommen. Mit einem Röntgengoniometer kann dann die Orientierung der kristallografischen Netzebene bezüglich dieser Referenzfläche bestimmt werden. Die Netzebenenausrichtung wird nun zur Referenzanschlagfläche in Beziehung gesetzt, woraus sich eine Winkeldifferenz ergibt, welcher hier die Genauigkeit repräsentiert.

Die Ausrichtung der Trennfläche bezüglich der Referenzfläche des zur Bestimmung der Netzebenenausrichtung verwendeten Verfahrens kann außer durch mechanischen Anschlag auch auf anderem Wege z. B. durch optische Verfahren erfolgen.

Neben der Bestimmung der globalen Orientierungsabweichung der verfahrensgemäß hergestellten Spaltfläche technologisch relevanter Länge kann auch eine lokale Orientierungsabweichung ermittelt werden, indem die technologisch relevante Länge in Teillängen von z. B. 2 mm unterteilt wird und deren Ausrichtung z. B. mittels eines optischen Mikroskops, eines Mniaturinterferometers, eines Weißlichtinterferometers oder eines Autokollimators erfolgt. Die Orientierungsgenauigkeit der Trennfläche entspricht dann der größten dieser gemessenen lokalen Abweichungen.

Die durch die Erfindung erzielten Spaltflächen sind durch bekannte Messverfahren z. B. durch das LEED-Verfahren als solche von Oberflächen einer Halbleiterscheibe mit anderer Orientierung unterscheidbar . , vgl. hierzu Qian, G.X., Martin, R.M., Chadi, D.J., in Phys. Rev. B, Vol. 37, p.1303. (1988) oder Bechstedt, F. "Principles of Surface Physics", Springer Verlag; ISBN 978-3-540-00635-0, Kapitel 1.2.4; Seiten 16-18. Ausgenutzt wird, dass natürliche Spaltflächen von III-V-Halbleitern lediglich eine relaxierte, jedoch keine rekonstruierte Anordnung der oberflächennahen Atome zeigen, wie das für andere Orientierungen der Fall ist..

Weitere Vorteile und Zweckmäßigkeiten ergeben sich aus der Beschreibung eines Ausführungsbeispieles anhand der Figuren. Von den Figuren zeigen:

Fig. 1    eine schematische Draufsicht auf einen zu spaltenden Wafer;

Fig. 2    die Energiefreisetzungsrate G und effektive Oberflächenenergie $2y_e$ bei Einhaltung einer ersten Bedingung;

Fig. 3    die Energiefreisetzungsrate G und effektive Oberflächenenergie $2y_e$ bei Einhaltung einer zweiten Bedingung;

Fig. 4    die Energiefreisetzungsrate G und effektive Oberflächenenergie $2y_e$ bei Einhaltung einer dritten Bedingung;

Fig. 5    die Energiefreisetzungsrate G und effektive Oberflächenenergie $2y_e$ bei Einhaltung seiner vierten Bedingung;

Fig. 6    eine erste Phase der Rissausbreitung;

Fig. 7    eine zweite Phase der Rissausbreitung, die durch die Relativbewegung der Spannungsfelder kontrolliert wird (z. B. in isotropen Werkstoffen);

Fig. 8    eine Phase der Rissausbreitung im Fall der Abweichung von der gewünschten Spaltrichtung bei Vorhandensein einer kristallographischen Spaltebene und unsymmetrischer Justierung der Spannungsfelder zu dieser;

Fig. 9    eine Phase der Rissausbreitung in der gewünschten Spaltrichtung bei ideal symmetrischer Justierung der Spannungsfelder zur Spaltebene;

Fig. 10   eine schematische Darstellung der Orientierung des Wafers in der Spaltvorrichtung;

Fig. 11   ein Beispiel für den Maximalfehler zwischen Position und Richtung der gewünschten Spaltebene zur Bewegungsrichtung und den erzeugten Spannungsfeldern im Startgebiet;

Fig. 12   ein Beispiel für den Maximalfehler zwischen Position und Richtung der gewünschten Spaltebene zur Bewegungsrichtung und den erzeugten Spannungsfeldern im Zielgebiet;

Fig. 13   die Energiefreisetzungsrate G. und G+ im Start- bzw. im Zielgebiet in Abhängigkeit vom Winkel $\alpha$; und

Fig. 14   eine Phase der Rissausbreitung unter Einhaltung der erfindungsgemäßen Bedingungen.

Nachfolgend wird die Erfindung anhand des Ausführungsbeispiels des Spaltens eines GaAs-Wafers mittels thermisch induzierten Spannungsfeldern beschrieben. Zunächst wird der Wafer in eine Spaltvorrichtung eingebracht. Die Ausrichtung des Wafers zur Spaltvorrichtung erfolgt an einer vorher angebrachten Markierung, z.B. einem kurzen Flat, welches z.B. mit Hilfe von Röntgendiffraktometrie gerichtet angeschliffen wird. Dabei ist in der Praxis eine Genauigkeit der Flatausrichtung zur {110}-Spalteben von 0,1° erreichbar. Auch andere Markierungen oder kurze Flats senkrecht oder in einem bestimmten Bezug zu den Spaltebenen sind als Vorjustierungshilfe denkbar. Die Vorjustierung zur Bewegungsrichtung kann mit Hilfe von Anschlägen oder mit optischen Methoden erfolgen.

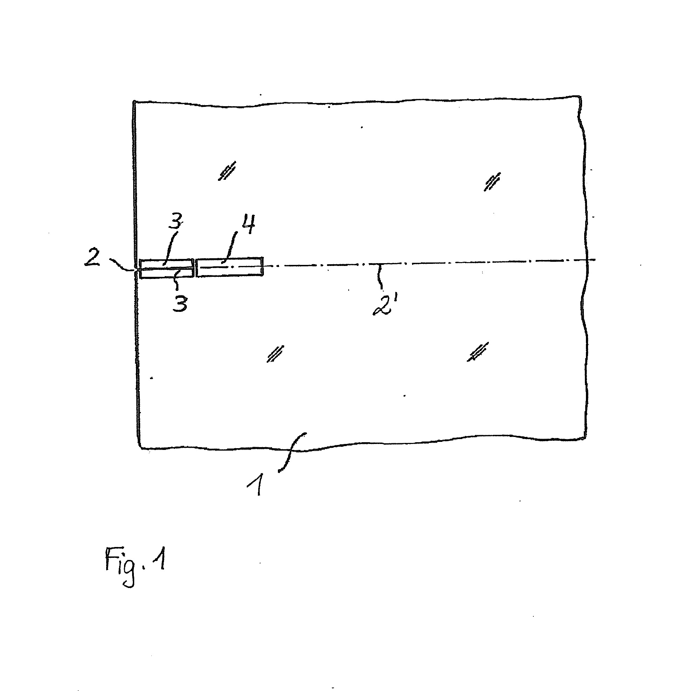

Wie schematisch aus Fig. 1 ersichtlich ist, wird in den GaAs-Wafer 1 ein Initialriss 2 in einer {110}-Spaltebene eingebracht. Idealerweise wird der Initialriss 2 in eine Spaltebene eingebracht, die parallel zu der bevorzugten Gleitrichtung der a-Versetzungen verläuft.

Der Initialriss 2 wird beispielsweise durch Eindruck mittels eines Indenters mit definierter Geometrie erzeugt (Vickers, Knoop-Indenter). Auch andere Geometrien oder ein Anritzen ist möglich. Durch Wahl der Eindrucklast und -geometrie kann die Ausbildung von senkrecht dazu gerichteten B-Rissen vermieden werden.

Durch thermisch induzierte Spannungsfelder wird aus dem eindruckinduzierten Riss ein ebener bis zur Waferrückseite durchgehender Randriss in der {110}-Spaltebene erzeugt, der als ebener Initialriss für die weitere Rissausbreitung bzw. die gewünschte Spaltrichtung bzw. Spaltebene 2' dient. Die thermisch induzierten Spannungsfelder werden in dieser Phase so dimensioniert, dass der Initialriss sich noch nicht weiter ausbreiten kann.

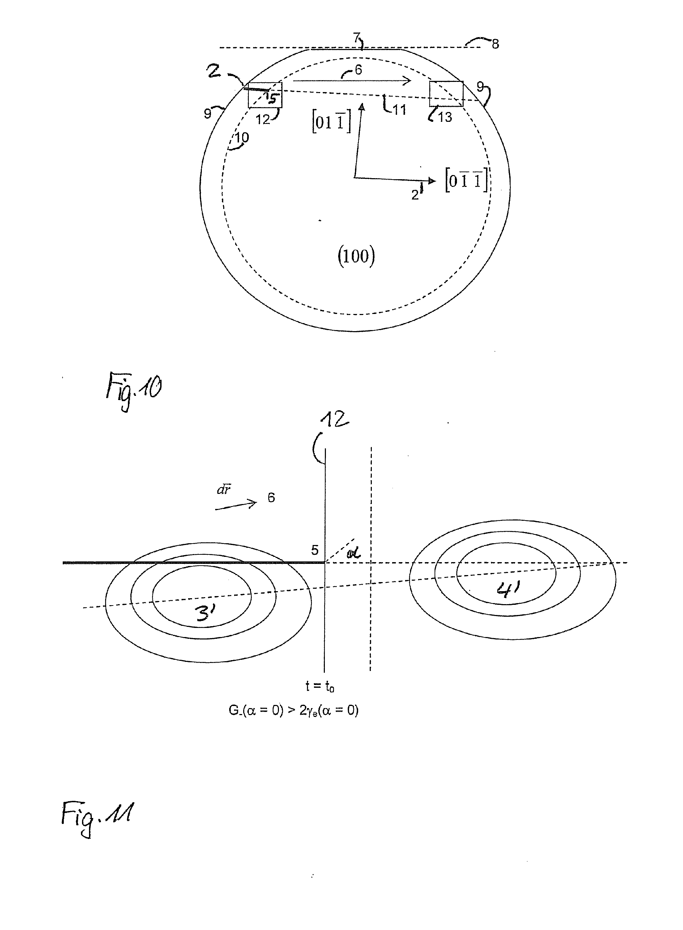

Dann wird zur Rissausbreitung eine Spannungsintensität K erzeugt und die Größe G($\alpha$) bestimmt, die die Energiefreisetzungsrate bei weiterer Rissausbreitung in Abhängigkeit von einer Ablenkung des Risses von der Spaltebene um den Winkel $\alpha$ ist. Die Rissausbreitung kann als Überlagerung einer Verwindung (twist- configuration) um den Winkel $\phi$ um eine Achse senkrecht zur Rissfront des Initialrisses und einer Drehung um den Winkel $\theta$ um die Rissfront des Initialrisses (tilt-configuration) betrachtet werden. Beide Fälle können getrennt betrachtet werden. Das beschriebene erfindungsgemäße Verfahren gilt für beide Fälle, sodass im weiteren der Bezug auf einen Ablenkwinkel $\alpha$ genügt (mit $\alpha = \theta$ für tilt- und $\alpha = \phi$ für twist configuration). Das Ausführungsbeispiel ist am Beispiel der tilt- configuration erläutert ohne die Gültigkeit für den allgemeinen Fall einzuschränken. Die Spannungsintensität K wird unter Nutzung bekannter Verfahren, wie beispielsweise das Verfahren gemäß der DE 28 13 302 oder das Verfahren der WO 93/20015 erzeugt. Dabei wird eine oder mehrere Wärmequellen 4 sowie eine oder mehrere Wärmesenken 3 (vgl. Fig. 11,12,14) auf eine oder beide Waferseiten aufgebracht, sodass idealerweise bezüglich der Waferdicke sowie zur gewünschten Spaltrichtung symmetrische Spannungsfelder vorliegen. Die Wärmequellen können z. B. durch Absorption von Laserstrahlen und die Wärmesenken durch gezielte Aufbringung von Kühlaerosolen erzeugt werden, wie dies beispielsweise in der WO 93/20015 beschrieben ist. Aber auch andere Varianten sind möglich. Die Wärmequellen und Senken werden so gesteuert und positioniert, dass ein Rissfortschritt ermöglicht wird.

Die Dimensionierung beziehungsweise Steuerung - oder auch eine Regelung - der Spannungsfelder erfolgt derart, dass kontinuierlich oder intervallweise ein Rissfortschritt erfolgt, der durch G (0) $\geq$ 2 $y_e$(0) gekennzeichnet ist. Erfindungsgemäß erfolgt die Dimensionierung bzw. Steuerung der Spannungsfelder ferner derart, dass zusätzlich mindestens eine der folgenden Bedingungen:

$$\left|\frac{\partial G}{\partial \alpha}\right|_{\alpha=0} \leq 2\frac{\beta_e}{h} \ \text{ wenn } \ \frac{\partial^2 G}{\partial \alpha^2} \leq 0 \qquad\qquad (2.1)$$

oder

$$\left|\frac{\partial G}{\partial \alpha}\right| \leq 2\frac{\beta_e}{h} \qquad\qquad \forall \alpha: \alpha_1 < \alpha < \alpha_2 \qquad\qquad (2.2)$$

erfüllt sind.

Es sind

$\alpha$      möglicher Ablenkwinkel bei Rissfortschritt von der Spaltebene

$\alpha_1, \alpha_2$      Winkelbereich, in dem die notwendige Bedingung für Rissausbreitung (1.1) gewährleistet ist

$G(\alpha)$      Energiefreisetzungsrate in Abhängigkeit von einer Ablenkung des Risses von der Spaltebene um den Winkel $\alpha$.

$\gamma_e$(0)      effektive Oberflächenenergie der Spaltfläche

$\gamma_e$      richtungsabhängige effektive Oberflächenenergie

$\beta_e$      effektive Stufenenergie (materialspezifisch)

h      Stufenhöhe (materialspezifisch).

Die effektive freie Oberflächenenergie $\gamma_e$, die aus der Bruchmechanik bekannt ist, wird in Bruchexperimenten aus dem Zusammenhang zwischen Bruchfestigkeit und Risslänge bestimmt. Sie enthält im Vergleich zur intrinsischen Oberflächenenergie $\gamma_s$ auch noch Energieanteile dissipativer Prozesse. Dazu gehören beispielsweise die Bildung von Versetzungen in der Prozeß- bzw. plastischen Zone, die Emission von Schallenergie oder das Auftreten von dissipativen Strukturen (Bruchstrukturen) auf den Bruchflächen. Sie ist somit größer als die intrinsische Oberflächenenergie $\gamma_s$.

Für die spezifische freie Stufenenergie findet man im thermodynamischen Gleichgewicht die folgenden Näherungsbeziehung:

$$\beta_e = -n k_B T \ln \eta (1 + 2\eta), \quad \eta = \exp(-\varepsilon / k_B T).$$

In ihr bedeuten: n - Stufendichte mit $n = 1/a$, $k_B$ - Boltzmann-Konstante, $\varepsilon$ - Bindungsenergie zwischen nächsten Nachbarn im Kristallgitter, a - Abstand der Bausteine in der Stufe.

Die Bindungsenergie $\varepsilon$ kann aus der Sublimationsenergie $\Delta H_{sub}(T)$ des Kristalles ("kongruente Verdampfung") und der Koordinationszahl Z des betrachteten Kristalles abgeschätzt werden:

$$\varepsilon \approx \Delta H_{sub} / Z,$$

$\Delta H_{sub}(T)$ gewinnt man aus einer Berechnung des thermodynamischen Gleichgewicht $X_s \Leftrightarrow X_g$ mit den thermodynamischen Daten der festen (s) und gasförmigen (g) Phase X.

Die freie Stufenenergie kann auch experimentell bestimmt werden.

Für GaAs können folgende Werte angenommen werden:

Die effektive freie Oberflächenenergie von GaAs {110}- Spaltflächen ergibt sich aus Bruchexperimenten zu $\gamma_e$(0) $\approx$ (0.86 $\pm$ 0.15) J/m$^2$. Durch bekannte Untersuchungen im Bereich der Rissfront wurde gesichert, dass dissipative Vorgänge vernachlässigt werden können, die gemessene effektive freie Oberflächenenergie also der intrinsischen Oberflächenenergie $\gamma_s$(0) $\approx$ 0.82 J/m$^2$, die sich aus Kristallzüchtung ergibt, nahekommt.

Für GaAs {110}/<001>, d. h. <001 > orientierte Stufen auf einer {110} Spaltfläche mit Kippachse parallel zu <001> wurde die Stufenenergie mit folgenden Daten abgeschätzt:

$$\Delta H_{sub}(300 \text{ K}) = 451,4 \text{ kJ/mol}, \ Z = 4 \Rightarrow \varepsilon \approx 1.17 \text{ eV und für } T = 300 \text{ K } \eta \approx 45.25.$$

Der Abstand der Atome in einer <001> parallelen Stufe beträgt $a_o$ = 0.565325 nm, die Höhe einer Doppelstufe ist $h = a_0/]2 = 0.399$ nm. Damit ergibt sich aus der obigen Formel die freie Stufenenergie zu:

$$\beta_e \approx 3,31 \text{x} 10^{-10} \text{ J/m}$$

und

$$\beta_e / \text{h} \approx 0.83 \text{ J/m}^2$$

Dieser Wert stimmt etwa mit der intrinsischen freien Oberflächenenergie $y_s \approx 0.82$ J/m$^2$ einer {110} Spaltfläche überein.

Für die freie Stufenenergie gilt sinngemäß die gleiche Aussage wie für die Oberflächenenergie. Die experimentelle effektive Stufenenergie kann aufgrund dissipativer Anteile größer sein als die hier abgeschätzte. Mit der Angabe der theoretisch ermittelten Stufenergie ist die rechte Seite in den Bedingungen (2.1) und (2.2) bekannt,

Durch Simulationsrechnungen werden die Spannungsfelder unter den gewählten Bedingungen der Wärmequellen und -senken berechnet. Aber auch die direkte Messung der Spannungen ist möglich, z.B. durch Spannungsdoppelbrechung, Ultraschallmikroskopie oder Mikro-Ramanspektroskopie. Daraus wird für das vorgegebene Spannungsfeld die Energiefreisetzungsrate in Abhängigkeit von möglichen Ablenkungen des Risses um den Winkel $\alpha$ berechnet. Durch Steuerung und Positionierung der Wärmequellen und -senken werden die Spannungsfelder so eingestellt, dass die oben genannten erfindungsgemäßen Bedingungen erfüllt sind.

Dabei existiert ein Winkelbereich $\alpha_1 < \alpha < \alpha_2$, in dem die Bedingung $G \geq 2\gamma_e$ erfüllt ist. Dieser Bereich hängt von den Spannungsfeldern und den Materialeigenschaften sowie der Dejustierung der verwendeten Spaltvorrichtung von der zu trennenden Spaltebene ab. Im Winkelbereich zwischen $\alpha_1$ und $\alpha_2$ ist die notwendige Bedingung (1.1) für eine Rissausbreitung erfüllt. Die erfindungsgemäße Steuerung bzw. Dimensionierung der Spannungsintensität K auf die Einhaltung der Bedingung (2.1) oder (2.2) sichert, dass dennoch der Riss nicht im Bereich $\alpha_1 < \alpha < \alpha_2$ abgelenkt wird, sondern über die gesamte zu trennende Distanz in der gewünschten Spaltebene verläuft.

Die unvermeidbare Dejustierung der Spaltvorrichtung, bzw. eine Spannungsintensität K mit gemischten Rissöffnungsmoden $K_I + K_{II} + K_{III}$, erzeugt eine zur gewünschten Rissausbreitungsrichtung in der Spaltebene $\alpha = 0$ unsymmetrischen Verlauf der Energiefreisetzungsrate $G(\alpha)$ in Abhängigkeit von möglichen Ablenkwinkeln $\alpha$. Ferner breitet sich der Riss in die Richtung aus, bei der die Größe $g = G - 2y_e$ maximal wird. Die erfindungsgemäße Steuerung bzw. Dimensionierung der Spannungsintensität K auf die Einhaltung der Bedingungen (2.1) oder (2.2) sichert, dass auch bei Dejustierung der Spaltvorrichtung, bzw. ein Spannungsintensität K mit gemischten Rissöffnungsmoden $K_I + K_{II} + K_{III}$ das Maximum der Grö-ße g immer bei $\alpha = 0$ liegt. Dadurch wird der Rissfortschritt in der gewünschten Netzebene durch eine Selbstjustierung der Rissausbreitungsrichtung erzwungen. Dadurch lassen sich kristallografische Spaltflächen mit hoher Orientierungsgenauigkeit im Bereich von mindestens $\leq |0,01°|$, $\leq |0,005°|$ oder sogar $\leq |0,001°|$ erzeugen. Weiterhin lassen sich kristallografische Spaltflächen mit einer minimalen Stufendichte, idealerweise ohne Stufen, über die gesamte technologisch relevante Fläche (Flats, Resonatorflächen o.ä.) erzeugen.

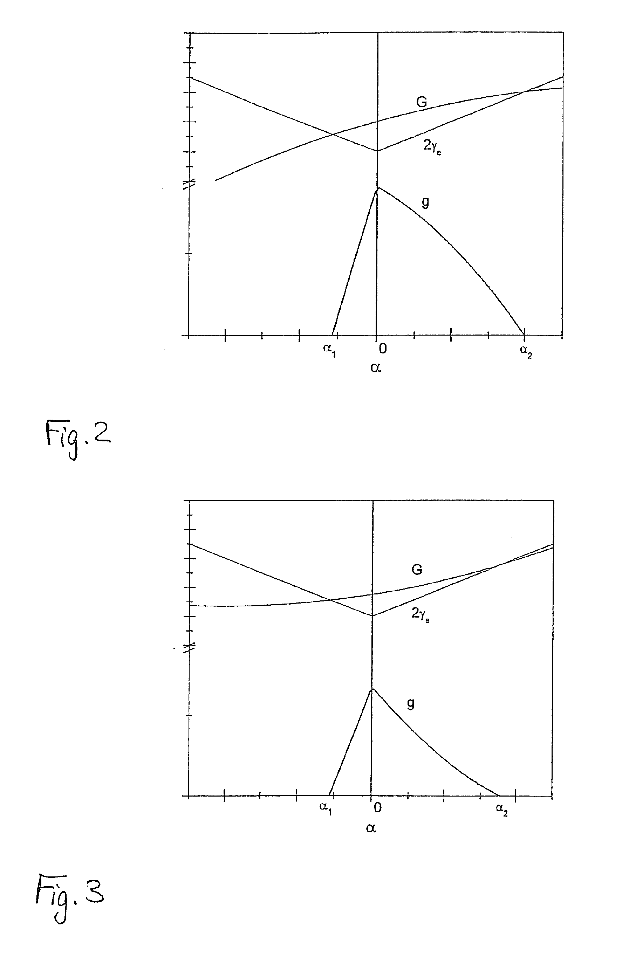

Zwei Situationen bei denen die erfindungsgemäßen Bedingungen eingehalten sind, sind in Fig. 2 und Fig. 3 dargestellt.

Fig. 2 zeigt die Energiefreisetzungsrate G und effektive Oberflächenenergie $2\gamma_e$ sowie $g = G - 2y_e$ bei Einhaltung

der Bedingung $\left|\dfrac{\partial G}{\partial \alpha}\right|_{\alpha=0} \leq 2\dfrac{\beta_e}{h}$ und $\dfrac{\partial^2 G}{\partial \alpha^2} \leq 0 \ \forall \alpha : \alpha_1 < \alpha < \alpha_2$.

Fig. 3 zeigt die Energiefreisetzungsrate G und effektive Oberflächenenergie $2y_e$ sowie $g = G - 2\gamma_e$ bei Einhaltung

der Bedingung $\left|\dfrac{\partial G}{\partial \alpha}\right| \leq 2\dfrac{\beta_e}{h} \quad \forall \alpha : \alpha_1 < \alpha < \alpha_2$.

Mit dem Verfahren können am Wafer Flächen, wie zum Beispiel Flats mit einer Orientierungsgenauigkeit von $0,01°$ - gemessen über Längen der jeweils technologisch relevanten Flächen - angebracht werden, d.h. die Genauigkeit, die in der Praxis durch einen Schleifprozeß erreicht werden kann, wird um eine Größenordnung erhöht. Das Verfahren sichert, dass die Justiergenauigkeit zwischen Bewegungsrichtung und Spaltebene von $0,1°$ ausreicht, um die Rissausbreitung in der Spaltebene mit einer Genauigkeit von $\leq 0,01°$ zu erzwingen. Erste Resultate zeigen, dass Genauigkeiten von $\leq 0,005°$ oder sogar $\leq 0,001°$ möglich sind. Schließlich ist auch die vollständig stufenfreie, ideale Spaltfläche möglich, die sich dann entlang der natürlichen kristallographischen Ebene erstreckt.

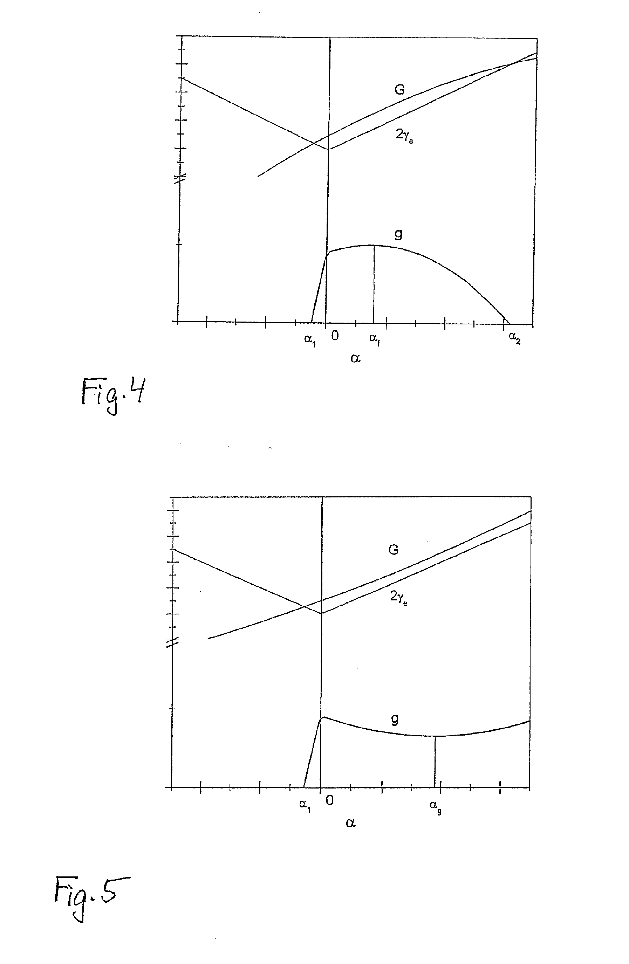

Fig. 4 und Fig. 5 zeigen Situationen, bei der eine Dejustierung der Spaltvorrichtung, bzw. eine Spannungsintensität K mit gemischten Rissöffnungsmoden vorliegt und die erfindungsgemäßen Bedingungen nicht eingehalten werden.

Fig. 4 zeigt die Energiefreisetzungsrate G und effektive Oberflächenenergie $2y_e$ sowie $g = G - 2y_e$ mit

$\left|\dfrac{\partial G}{\partial \alpha}\right|_{\alpha=0} > 2\dfrac{\beta_e}{h}$ . In Fig. 4 erfolgt die Rissausbreitung bei $\alpha = \alpha_f$ d.h. der Riss weicht von der gewünschten Spaltrichtung $\alpha = 0$ ab. Es entstehen auf der erzeugten Fläche Stufen oder gekrümmte Flächen. Die technologisch relevanten Flächen (Flats, Resonatorflächen) besitzen nicht die gewünschte Orientierungsgenauigkeit oder Qualität.

Fig. 5 zeigt die Energiefreisetzungsrate G und effektive Oberflächenenergie $2y_e$ sowie $g = G - 2\gamma_e$ mit

$\left|\dfrac{\partial G}{\partial \alpha}\right| > 2\dfrac{\beta_e}{h}$ für $\alpha > \alpha_g$ . In Fig. 5 ist der Rissverlauf bei $\alpha = 0$ nicht stabil. Bei einer Überschreitung des Winkels $\alpha \geq \alpha_g$ erfolgt eine Abweichung des Rissverlaufes von der gewünschten Ebene $\alpha = 0$.

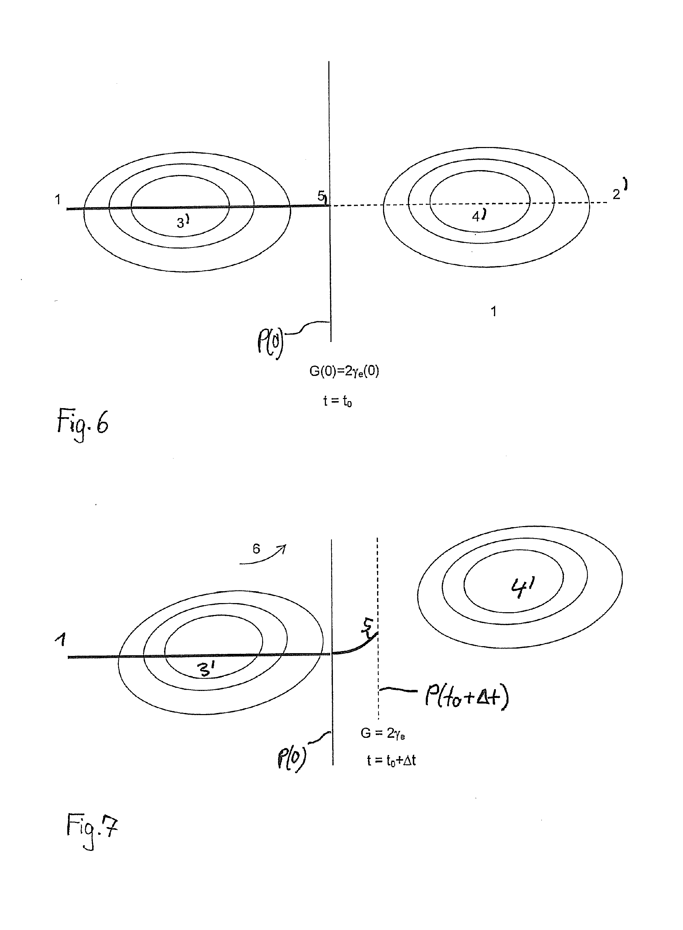

Die Figuren 6 bis 9 zeigen verschiedene Fälle der Rissausbreitung im Wafer. Durch Steuerung und Positionierung der Wärmequellen und Wärmesenken wird ein Druckspannungsmaximum 4' und ein Zugspannungsmaximum 3' erzeugt. Die Wärmequellen und -senken werden so positioniert, dass das Druckspannungsmaximum 4' vor der Rissspitze 5 in Ausbreitungsrichtung und das Zugspannungsmaximum 3' hinter der Rissspitze 5 positioniert wird, wie in Fig. 6 gezeigt ist. Im Bereich zwischen Zug- und Druckspannungsmaxima ist zum Zeitpunkt $t = t_0$ an einer bestimmten Position P(0) die Bedingung $K = K_c$ bzw. $G\,2\gamma_e$ erfüllt. Durch Relativbewegung zwischen Temperaturfeldern und Wafer, die in Fig. 7 durch den Pfeil 6 angedeutet ist, können die Bedingungen (1.1) $K > K_C$ bzw. $G > 2\gamma_e$ oder (1.2) $K \leq K_C$ bzw. $G \leq 2y_e$ kontrolliert werden, d.h. die Rissspitze 5 kann geführt, gezielt gestoppt oder weiterbewegt werden. Die Relativbewegung kann durch die Bewegung der Wärmequellen und Senken (Laserfokus und Kühldüsen) oder aber auch durch eine Bewegung des Wafers oder eine Kombination aus beiden erfolgen. Dissipative oder dynamische Effekte können durch die Kontrolle der Ausbreitungsgeschwindigkeit vermieden werden. Die Ausbreitungsgeschwindigkeit kann hinreichend klein gewählt werden, dass quasistatische Rissausbreitung und thermodynamisches Gleichgewicht vorausgesetzt werden können (v <<1/3 der Schallgeschwindigkeit). Der Rissverlauf folgt der Relativbewegung 6 zwischen den Spannungsfeldern und dem Wafer 1. Dies wird im Stand der Technik genutzt, um auch komplizierte Geometrien zu schneiden, die geradlinig oder krummlinig sein können.

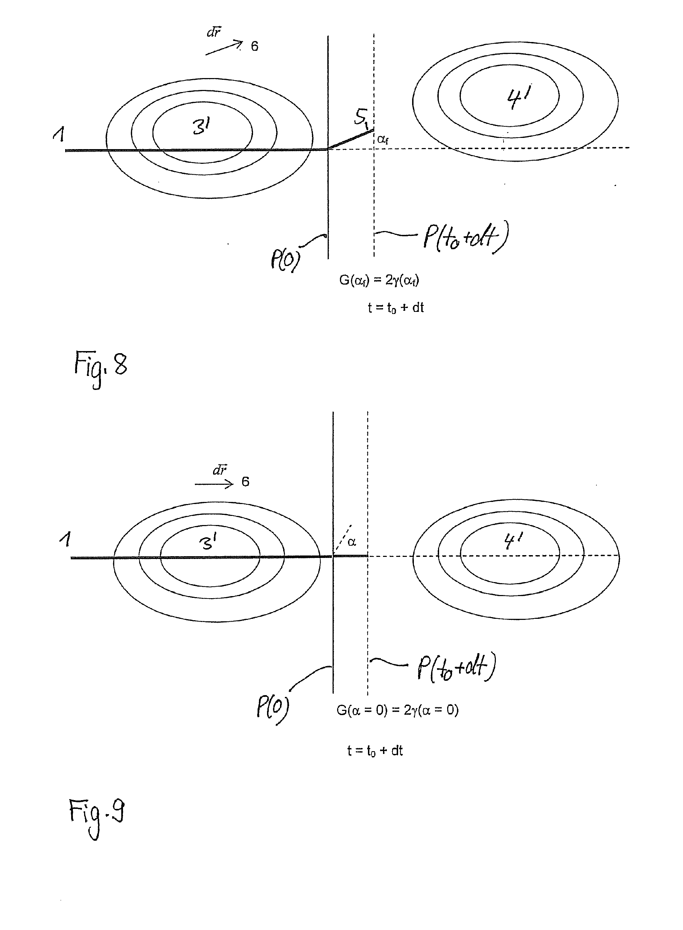

Bei der Anwesenheit von kristallografischen Spaltebenen konkurrieren während der Relativbewegung 6 zwischen den Spannungsfeldern und dem Wafer, wie oben beschrieben, der Einfluss der Spaltebenen mit dem der Spannungsfelder 3' und 4' bzw. die Spaltrichtung 2' mit der Bewegungsrichtung 6 der Vorrichtung während des Risswachtums miteinander. Diese Situation ist in Fig. 8 dargestellt. Bei einer infinitesimalen Relativbewegung 6 um $d\bar{r}$ wird der Riss aufgrund des Energieprinzips (1.3) im Allgemeinen um den Winkel $\alpha_f$ abgelenkt. Das entspricht der Situation in Fig. 4. Die Rissspitze befindet sich an der Position P($t_0$+dt), wo die Bedingung $G(\alpha_f) = 2\gamma_e(\alpha_f)$ nach einer Zeit t = $t_0$+dt erreicht wird (quasistatische Rissausbreitung). Auf diese Weise werden im Allgemeinen unerwünschte

Stufen auf den Spaltebenen erzeugt oder es kommt zu Abweichungen von der gewünschten Spaltrichtung.

Um die Konkurrenz zwischen Spaltrichtung und Spannungsfeldern zu vermeiden, müsste nach bekannten bruchmechanischen Prinzipien idealerweise die maximalen Zugspannungen senkrecht zur gewünschten Spaltebene gerichtet sein. Um diese Situation am besten zu erreichen, müsste eine ideal symmetrische Justierung der Spannungsfelder 4' und 3' (d.h. Wärmequelle bzw. -senke) zur Spaltebene durchgeführt werden, die auch während des gesamten Trennvorganges, d.h. über Distanzen des Durchmessers eines GaAs- Wafers, aufrechterhalten werden muss. Das heisst, dass auch die Bewegungsrichtung 6 der Vorrichtung ideal parallel zur Spaltebene 2' und sowie zur Symmetrielinie der Spannungsfelder justiert werden muss. Diese Situation ist in Fig. 9 dargestellt. Nach einer Relativbewegung um $d\bar{r}$ verbleibt die Rissspitze an der Position P($t_0$+dt), an der die Bedingung $G(0) = 2y_e(0)$ nach einer Zeit t = $t_0$+dt erreicht wird. Das heißt der Riss verläuft in der Spaltebene. Diese ideale Situation ist in der Praxis jedoch nicht erreichbar. Das würde die Messung und Justierung der Spaltebene zu den Wärmequellen und -senken sowie zur Bewegungsrichtung der Vorrichtung mit sehr hoher Präzision erfordern, die unter produktionstechnischen und wirtschaftlichen Gesichtspunkten nicht erreichbar ist. Mit Hilfe der Erfindung wird dennoch eine Fläche erzeugt die mit sehr hoher Genauigkeit orientiert ist.

Fig. 10 zeigt die Orientierung des Wafers 1 in der Spaltvorrichtung. Wie oben beschrieben, ist üblicherweise eine Markierung bzw. ein kurzes Flat 7 vorhanden, welches mit einer gewissen Orientierungstoleranz zur den kristallographischen Richtungen angeschliffen wird. Dabei ist unter praktischen Bedingungen mit vertretbarem Aufwand eine Genauigkeit der Flatausrichtung 8 zu den {110}- Spaltebenen von 0,1˚ erreichbar. Das Flat 7 ist zur Bewegungsrichtung 6 der Relativbewegung zwischen Sparmungsfeldern und Wafer vorjustiert. Mit dem erfindungsgemäßen Trennverfahren wird am Wafer eine Fläche (Flat) mit einer Orientierungsgenauigkeit von ≤ |0,01˚| angebracht, d.h. die Genauigkeit, die in der Praxis durch einen Schleifprozess erreicht werden kann, um eine Größenordnung erhöht. Das erfindungsgemäße Verfahren sichert, dass die Justiergenauigkeit zwischen Bewegungsrichtung 6 und Spaltebene 2' von 0,1˚ ausreicht, um die Rissausbreitung in der Spaltebene mit einer Genauigkeit von mindestens ± 0,01˚ zu erzwingen. Das kann von Waferrand 9 zu gegenüberliegenden Waferrand 9 geschehen oder es kann ein gewisser Bereich 10 existieren, innerhalb dessen die Forderung der Orientierungsgenauigkeit des zu erzeugenden Flats 11 erfüllt sein muss. Die Größe und Geometrie dieses Bereiches 10 kann variieren und hängt von verschiedenen technologischen Forderungen ab. Genauigkeiten von ≤ |0,005˚|oder sogar ≤ |0,001˚| sind auch möglich, sowie auch das exakt stufenfreie Spalten entlang der kristallographischen Ebene.

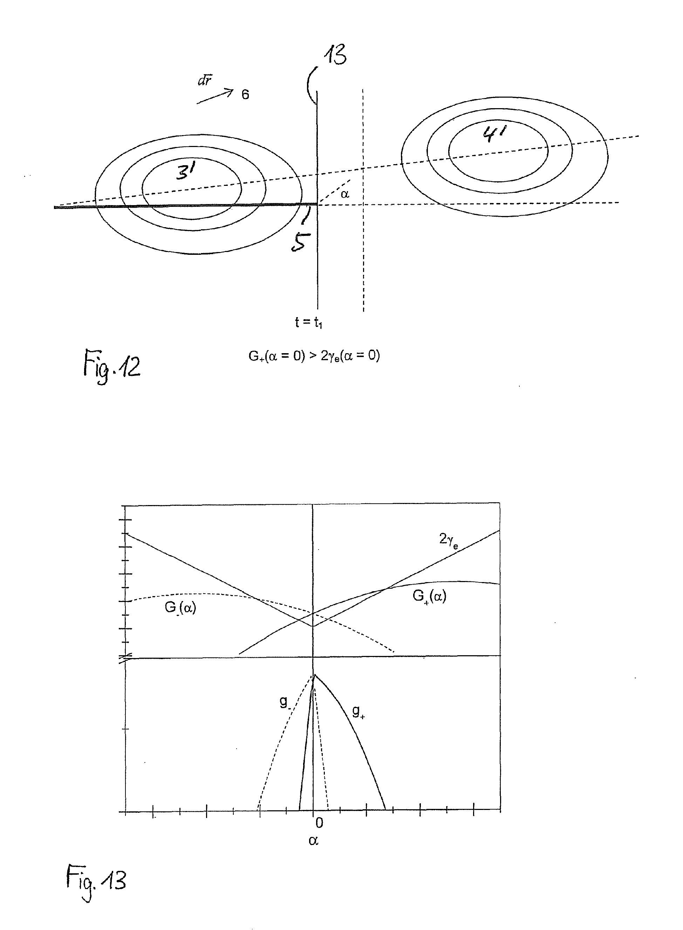

Durch Simulationsrechnungen im Vorfeld werden die Spannungsfelder vorzugsweise unter den gewählten Bedingungen der Wärmequellen und -enken berechnet. Die Simulation wird in den Gebieten am vorgesehenen Start- und Zielpunkt des Trennvorganges durchgeführt. Das kann z.B. an den Rändern des technologisch genutzten Bereiches 10 in den Gebieten 12 und 13 geschehen. Wobei der durch die oben beschriebenen Verfahren eingebrachte Initialriss 2 in der Spaltebene am Rand des Startgebietes 12 vorhanden ist, vorzugsweise außerhalb des Bereiches 10. Aber auch andere Positionen sind möglich. Die Proportionen in Fig. 10 sind nicht maßstabsgerecht und zur Veranschaulichung der Situation übertrieben dargestellt. Die bekannten vorliegenden Messgenauigkeiten (z.B. bei der Röntgendiffraktometrie), die bekannten Toleranzen beim Schleifen und die bekannten Positioniergenauigkeiten bestimmen den maximal möglichen Fehler bei der Vorjustierung des Wafers. So ist es beispielsweise mit Hilfe einfacher geometrischer Beziehungen möglich, den Maximalfehler zwischen Position und Richtung der gewünschten Spaltebene zur Bewegungsrichtung 6 und zu den erzeugten Spannungsfeldern 3' und 4' im Start- und Zielgebiet des Trennvorganges 12 und 13 zu bestimmen. Fig. 11 zeigt ein Beispiel für den Maximalfehler im Startgebiet 12. Fig. 12 zeigt ein Beispiel für den Maximalfehler im Zielbereich 13. Aber auch gespiegelte Positionen sind möglich.

Nun kann bei den gegebenen Spannungsfeldern in der Startposition 12 der Rissspitze 5 des Initialrisses die Energiefreisetzungsrate für den Fall der infinitesimalen Rissausbreitung in Abhängigkeit von möglichen Ablenkungen um den Winkel $\alpha$ berechnet werden. Das gleiche kann berechnet werden im geplanten Zielgebiet 13 unter der Annahme, dass der Riss die Spaltebene 2' nicht verlassen hat. Dadurch entstehen zwei Funktionen $G_-(\alpha)$ und $G_+(\alpha)$, die durch die bekannten Maximalfehler in der Start- und Zielpositionen gegeben sind. Die wahre Funktion $G(\alpha)$ ist nicht bekannt, stellt aber einen Zustand zwischen $G_-(\alpha)$ und $G_+(\alpha)$ dar.

Durch Dimensionierung und Positionierung der Wärmequellen und -enken werden nun die Spannungsfelder so eingestellt, dass die erfindungsgemäßen Bedingungen

$$\left|\frac{\partial G}{\partial \alpha}\right|_{\alpha=0} \leq 2\frac{\beta_e}{h} \qquad (3.1.)$$

und

$$\frac{\partial^2 G}{\partial \alpha^2} \leq 0 \qquad (3.2)$$

.

für beide Funktionen $G_-(\alpha)$ und $G_+(\alpha)$ erfüllt sind. Damit wird gewährleistet, dass für jeden Zwischenzustand $G(\alpha)$ ebenfalls die erfindungsgemäßen Bedingungen erfüllt sind und der Riss während des gesamten Trennvorganges in seiner Spaltebene verbleibt.

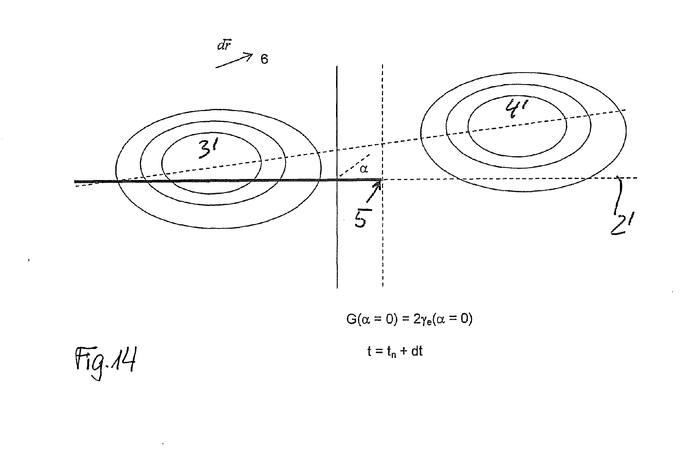

Fig. 13 zeigt ein Beispiel einer abgeglichenen Situation. Mit der Einhaltung der erfindungsgemäßen Bedingung für beide Funktionen $G_-(\alpha)$ und $G_+(\alpha)$ hat die Funktion g auch in allen möglichen (nicht bekannten) Zwischenzuständen während des Trennvorganges ihr Maximum bei $\alpha = 0$ und eine Selbstjustierung des Risses in der Spaltebene ist für den gesamten Trennprozess zwischen Start- und Zielposition gewährleistet. Eine Ablenkung des Risses, wie sie in Fig. 7 gezeigt ist, wird unterdrückt und die Rissspitze bewegt sich in jedem Zeitpunkt des Trennvorganges t = $t_n$+dt in die Spaltrichtung $\alpha = 0$, wie in Fig. 14 gezeigt ist.

Die Berechnung der Funktionen $G_-(\alpha)$ und $G_+(\alpha)$ und der Abgleich der Spannungsfelder ist auch iterativ sowie für alle möglichen Kombinationen von bekannten Maximalfehlern bei der Vorjustierung möglich. Die Steuerung und Dimensionierung der Spannungsfelder ist mit den bekannten Verfahren leicht z.B. über Steuerung der Laserleistung und/oder die Variation des Laserfokus und/oder die Anordnung der Kühldüsen zum Laserspot möglich. Aber auch andere Möglichkeiten sind denkbar.

Das Verfahren kann ferner auch so ausgeführt werden, dass beim Schritt der Prüfung der Bedingungen (2.1) oder (2.2) ein maximal zulässiger Winkelbereich $\alpha_1 < \alpha < \alpha_2$ ermittelt wird. In diesem Bereich muss gelten: $\dfrac{\partial^2 G}{\partial \alpha^2} \leq 0$

im Fall von Bedingung (2.1) bzw. $G(\alpha) \geq 2\gamma_e(\alpha)$ im Fall von Bedingung (2.2). Der ermittelte Winkelbereich wird mit einem vorab bekannten und nun vorgegebenen, möglichen Justagefehler einer Ausrichtung der kristallographischen Spaltebene (2') relativ zur Trennvorrichtung verglichen. Die Steuerung der Spannungsfelder (3', 4') und/oder der Anpassung der Vorjustierung wird dann in Abhängigkeit von dem Vergleich vorgenommen.

Die Erfindung ist nicht auf das Trennen von GaAs - Wafern, die als Ausführungsbeispiel beschrieben ist, beschränkt. Sie ist auf alle Einkristalle anwendbar. Angenäherte Zahlenwerte für $CaF_2$ (111)-Fläche sind z.B. $\gamma s \approx 0.47$ $J/m^2$ (ab initio Hartree-Fock Rechnungen) und $\beta_e \approx (3,31 - 6.8)\text{x}10^{-10}$ J/m und mit h = 0.32 nm: $\beta_e/h \approx (1.03 - 2.13)$ $J/m^2$.

Ferner bezieht sich die Erfindung nicht nur auf das Trennen von Scheiben, Wafern oder Teilen davon zur Bildung von Flats. Besonders auch die Vereinzelung von Einkristallen ist von der Erfindung eingeschlossen, die vorher z.B. epitaktisch oder im Rahmen von Abscheideverfahren beschichtet und ggf. lithographisch strukturiert wurden, und/oder aus denen dann beispielsweise integrierte Schaltkreise oder opto-elektronische Bauelemente, insbesondere Laser- oder Lumineszenzdioden hergestellt wurden/werden.

Ferner ist die Erfindung auch auf Einkristalle anwendbar, die als einkristalline Schichten auf einem einkristallinen Substrat gebildet wurden. Schicht und Substrat können dabei aus artgleichem oder auch artfremdem Material gebildet sein.

Im Ausführungsbeispiel wurde eine spezielle Anordnung der Spannungsfelder beschrieben, wobei nämlich die Rissfront im Spannungsfeld zwischen Temperatursenke und Temperaturquelle gehalten wurde. Die Erfindung ist allerdings nicht auf diese spezielle Anordnung beschränkt. Zum Beispiel können Spannungsfelder auch nur durch eine Temperaturquelle oder nur durch eine Temperatursenke vorgesehen sein, und/oder die Rissfront befindet sich nicht hinter sondern vor dieser Senke oder Quelle.

Die Erfindung ist auch als Computerprogrammprodukt umsetzbar, das zur Durchführung und Steuerung der Schritte nach einem der beigefügten Verfahrensansprüche eingerichtet ist.

**Patentansprüche**

1. Einkristall, ausgebildet als vorzugsweise epitaktisch aufgewachsene Schicht auf einem Substrat, oder als Wafer, Scheibe oder Teilen davon, mit einer technologisch erzeugten Spaltfläche, die sich mit einer Winlcelabweichung im Bereich von 0,02˚ bis —0,02˚ entlang einer natürlichen kristallographischen Spaltebene gemessen über die jeweils technologisch relevante Ausdehnung des Einkristalls oder über jede einer Vielzahl von Flächen mit einer Längsausdehnung in Trennrichtung von ≥ 2 mm innerhalb der technologisch relevanten Fläche erstreckt.

2. Einkristall nach Anspruch 1, wobei sich die technologisch erzeugte Spaltfläche mit einer Winkelabweichung im Bereich von + 0.01˚ bis - 0,01˚ entlang der natürlichen kristallographischen Spaltebene erstreckt.

3. Einkristall nach Anspruch 2, wobei sich die technologisch erzeugte Spaltfläche mit einer Winkelabweichung im Bereich von 0.005˚ bis — 0.005˚ entlang der idealen kristallographischen Spaltebene erstreckt.

4. Einkristall nach Anspruch 3, wobei sich die technologisch erzeugte Spaltfläche mit einer Winkelabweichung im Bereich von 0.001˚ bis — 0.001˚ entlang der natürlichen kristallographischen Spaltebene erstreckt.

5. Einkristall nach Anspruch 4, wobei sich die technologisch erzeugte Spaltfläche exakt entlang der natürlichen kristallographischen Spaltebene erstreckt.

6. Einkristall nach Anspruch 1, bei dem das Substrat aus einem artgleichem Material wie der Einkristall gebildet ist, oder
bei dem das Substrat aus einem vom Einkristall artfremden Material gebildet ist.

7. Einkristall nach Anspruch 1, bei dem auf wenigstens einer der beiden Hauptflächen der Scheibe eine oder mehrere Schicht(en) aus einem vom Einkristall abweichenden Material aufgebracht sind.

8. Einkristall nach Anspruch 7, bei dem die eine oder die mehreren Schicht(en) eine anhand von lithographischen Verfahren gebildete Strukturierung aufweisen.

9. Einkristall nach Anspruch 8, bei dem die Strukturierung der einen oder mehreren Schicht(en) einen oder mehrere elektrische Schaltkreise repräsentiert.

10. Einkristall nach Anspruch 7 oder 8, bei dem die Strukturierung und/oder die Zusammensetzung der Schichten zur Ausbildung von opto-elelctronischen Bauelementen, insbesondere Laser- und Lumineszenzdioden, eingerichtet ist.

11. Einkristall nach einem der Ansprüche 1 bis 8, wobei der Einkristall ein Wafer, die technologisch erzeugte Spaltfläche ein Flat und die technologisch relevante Ausdehnung des Einkristalls die Flatlänge ist.

Fig. 1

Fig. 2

Fig. 3

Fig.4

Fig.5

$P(0)$

$G(0) = 2\gamma_e(0)$

$t = t_0$

Fig. 6

$P(t_0 + \Delta t)$

$G = 2\gamma_e$

$t = t_0 + \Delta t$

$P(0)$

Fig. 7

$G(\alpha_f) = 2\gamma(\alpha_f)$

$t = t_0 + dt$

Fig. 8

$G(\alpha = 0) = 2\gamma(\alpha = 0)$

$t = t_0 + dt$

Fig. 9

Fig. 10

$$G_-(\alpha = 0) > 2\gamma_e(\alpha = 0)$$

Fig. 11

Fig. 12

$$G_+(\alpha = 0) > 2\gamma_e(\alpha = 0)$$

Fig. 13

Fig.14

$$G(\alpha = 0) = 2\gamma_e(\alpha = 0)$$

$$t = t_n + dt$$

Europäisches
Patentamt

European
Patent Office

Office européen
des brevets

**EUROPÄISCHER RECHERCHENBERICHT**

Nummer der Anmeldung

EP 11 17 4244

| | **EINSCHLÄGIGE DOKUMENTE** | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| X | US 6 252 197 B1 (HOEKSTRA BRIAN L [US] ET AL) 26. Juni 2001 (2001-06-26) <br> * Spalte 3 - Spalte 6; Abbildungen 1-5 * <br> * Spalte 11 - Spalte 12 * <br> ----- | 1-10 | INV. <br> B28D5/00 <br> H01L21/78 |
| X | BELSINGER H E JR ET AL: "A fracture criterion for gallium arsenide wafers", ENGINEERING FRACTURE MECHANICS UK, Bd. 48, Nr. 2, Mai 1994 (1994-05), Seiten 199-205, XP002518266, ISSN: 0013-7944 <br> * das ganze Dokument * <br> ----- | 1-5 | |
| X | EP 0 961 328 A2 (SUMITOMO ELECTRIC INDUSTRIES [JP]) 1. Dezember 1999 (1999-12-01) <br> * Absätze [0004], [0030] - Absatz [0033]; Ansprüche; Abbildungen * <br> ----- | 1-10 | |
| X | SINK R.K. ET AL.: "Cleaved GaN facets by wafer fusion of GaN to InP", APPLIED PHYSICS LETTERS, AIP, AMERICAN INSTITUTE OF PHYSICS, MELVILLE, NY, US, Bd. 68, Nr. 15, 8. April 1996 (1996-04-08), Seiten 2147-2149, XP012015030, ISSN: 0003-6951, DOI: 10.1063/1.115613 <br> * das ganze Dokument * <br> ----- | 1-10 | RECHERCHIERTE SACHGEBIETE (IPC) <br><br> B28D <br> H01L <br> B23K |
| X | EP 1 768 181 A1 (SUMITOMO ELECTRIC INDUSTRIES [JP]) 28. März 2007 (2007-03-28) <br> * Absätze [0031] - [0034], [0048] - Absatz [0057] * <br> ----- | 1-4,11 | |
| X | JP 2006 024839 A (SUMITOMO METAL MINING CO) 26. Januar 2006 (2006-01-26) <br> * Absätze [0027], [0036] - [0039] * <br> ----- | 1-5,11 | |
| | Der vorliegende Recherchenbericht wurde für alle Patentansprüche erstellt | | |

| Recherchenort | Abschlußdatum der Recherche | Prüfer |
|---|---|---|
| Den Haag | 15. August 2011 | Bakker, Jeroen |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 11 17 4244

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-08-2011

| Im Recherchenbericht angeführtes Patentdokument | | Datum der Veröffentlichung | Mitglied(er) der Patentfamilie | | Datum der Veröffentlichung |
|---|---|---|---|---|---|
| US 6252197 | B1 | 26-06-2001 | KEINE | | |
| EP 0961328 | A2 | 01-12-1999 | JP | 11340576 A | 10-12-1999 |
| | | | TW | 427037 B | 21-03-2001 |
| | | | US | 2002063258 A1 | 30-05-2002 |
| EP 1768181 | A1 | 28-03-2007 | CN | 1929088 A | 14-03-2007 |
| | | | CN | 101562128 A | 21-10-2009 |
| | | | HK | 1101220 A1 | 15-01-2010 |
| | | | JP | 2007073761 A | 22-03-2007 |
| | | | KR | 20070028227 A | 12-03-2007 |
| | | | US | 2007080366 A1 | 12-04-2007 |
| JP 2006024839 | A | 26-01-2006 | KEINE | | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5279077 A
- US 5439723 A
- US 5154333 A
- DE 2813302
- WO 9320015 A

**In der Beschreibung aufgeführte Nicht-Patentliteratur**

- **QIAN, G.X. ; MARTIN, R.M. ; CHADI, D.J.** *Phys. Rev. B,* 1988, vol. 37, 1303
- **BECHSTEDT, F.** Principles of Surface Physics. Springer Verlag, 16-18